# EUROPÄISCHE PATENTSCHRIFT

(11) **EP 3 410 135 B1**
(45) Veröffentlichungstag und Bekanntmachung des Hinweises auf die Patenterteilung: **14.04.2021**
(21) Anmeldenummer: 18174979.7
(22) Anmeldetag: 30.05.2018
(51) Int. Cl.: G01R 31/319, G01R 1/44, G01R 31/28

(54) **KONTAKTKOPF FÜR EINE ELEKTRISCHE PRÜFEINRICHTUNG, PRÜFEINRICHTUNG**
CONTACT HEAD FOR AN ELECTRICAL TESTING DEVICE, TESTING DEVICE
TÊTE DE CONTACT POUR UN DISPOSITIF D'ESSAI ÉLECTRIQUE, DISPOSITIF D'ESSAI

(30) Priorität: 31.05.2017 DE 102017209254
(43) Veröffentlichungstag der Anmeldung: 05.12.2018
(73) Patentinhaber: Feinmetall GmbH, 71083 Herrenberg (DE)
(72) Erfinder: Treuz, Stefan, 72411 Bodelshausen (DE); Tabakow, Denis, 71034 Böblingen (DE); Kopilas, Berislav, 75382 Althengstett (DE)
(74) Vertreter: Clarenbach, Carl-Philipp

(56) Entgegenhaltungen:
- DE-A1-102004 023 987
- DE-A1-102006 054 734

## Beschreibung

Die Erfindung betrifft einen Kontaktkopf für eine elektrische Prüfeinrichtung zur elektrischen Prüfung von Substraten, die elektrische Kontaktstellen, insbesondere elektrische Leiter und/oder elektrische/elektronische Komponenten aufweisen, mit zumindest zwei Führungsplatten, die durch einen Abstandshalter parallel zueinander angeordnet sind und jeweils mehrere miteinander fluchtende oder versetzte Führungsöffnungen zur Aufnahme stiftförmiger Kontaktelemente aufweisen und durch eine Zentriereinrichtung zueinander ausgerichtet sind, wobei die Zentriereinrichtung vier Zentrierstifte aufweist, die in jeweils einem sich auf ein Zentrum des Kontaktkopfs zu erstreckenden Langloch in zumindest einer der Führungsplatten verschiebbar gelagert sind, und wobei die Zentrierstifte jeweils in einer Zentrieröffnung des Abstandshalters gehalten sind.

Weiterhin betrifft die Erfindung eine elektrische Prüfeinrichtung zur elektrischen Prüfung von Substraten, die elektrische Leiter und/oder elektrische/elektronische Komponenten aufweisen.

Elektrische Prüfeinrichtungen der eingangs genannten Art dienen dazu, einen Prüfling beziehungsweise das Substrat mit den elektrischen Leitern und/oder Komponenten elektrisch zu kontaktieren, um die Funktionsfähigkeit des Substrats zu prüfen. Die Prüfeinrichtung stellt elektrische Verbindungen zu dem Substrat her, indem Sie einerseits das Substrat beziehungsweise die elektrischen Leiter oder elektrische Kontaktstellen des Substrats kontaktiert und andererseits elektrische Kontakte zur Verfügung stellt, die mit einem Prüfsystem verbunden werden, sodass das Prüfsystem über die Prüfeinrichtung dem Prüfling elektrische Signale zuführen kann, um für eine Funktionsprüfung beispielsweise Widerstandsmessungen, Stromund Spannungsmessungen oder dergleichen durchzuführen. Weil es sich bei den zu prüfenden Substraten, wie beispielsweise Wafer, Leiterplatten oder Solarzellen, oftmals um extrem kleine Bauteile oder um Bauteile mit einer hohen Dichte von elektrischen Kontaktstellen handelt, sind Kontaktelemente mit kleinen Abmessungen notwendig, um auf kleinem Raum einen hohen Abtastgrad beziehungsweise Kontaktierungsgrad erreichen zu können. Üblicherweise sind dabei die Führungsöffnungen in den Führungsplatten entsprechend der elektrischen Kontaktstellen an dem Prüfling angeordnet, sodass die Kontaktelemente entsprechend positioniert werden.

Weil bei der Durchführung der Prüfung unterschiedliche Raum- und/oder Prüfungstemperaturen vorliegen können, ist es erforderlich, dass thermisch bedingte Längenänderungen der Prüfeinrichtung nicht dazu führen, dass die Positionierung der Kontaktelemente in Bezug auf die elektrischen Kontaktstellen an dem Prüfling beziehungsweise dem Substrat abweichen, wodurch eine Prüfung nicht mehr erfolgreich durchgeführt werden könnte. Es ist daher bekannt, Zentriervorrichtungen vorzusehen, die ein Temperaturausdehnungsspiel in der Prüfeinrichtung derart erlauben, dass ein Versatz der Kontaktelemente durch temperaturbedingte Mengenänderungen minimal ist.

Hierzu zeigt beispielsweise die Offenlegungsschrift DE 10 2004 023 987 A1 eine elektrische Prüfeinrichtung mit einer Zentriereinrichtung, die in Bezug auf das Zentrum der Prüfeinrichtung beziehungsweise des Kontaktkopfes, also das Zentrum in einer Ebene parallel zu den Führungsplatten, ein nur radiales, also auf das Zentrum oder von dem Zentrum weg führendes, Temperaturspiel zulässt. Durch die radiale Ausrichtung auf das Zentrum wird erreicht, dass insgesamt ein minimaler Versatz bei temperaturbedingten Mengenänderung erfolgt, weil sich Längenänderungen in der jeweiligen Platte nicht über die gesamte Breite der jeweiligen Führungsplatte aufaddieren können.

Die Zentriereinrichtung weist dazu mehrere Zentrierstifte auf, die an dem Abstandshalter in Zentrieröffnungen befestigt sind und in Langlöchern in den Führungsplatten einliegen, wobei die Langlöcher in ihrer Längserstreckung radial zum Zentrum ausgerichtet sind. Damit ein einwandfreier Betrieb gewährleistet ist, sind dabei hohe Toleranzanforderungen an Zentrierstifte, Langlöcher und Zentrieröffnungen zu erfüllen. Die Zentrieröffnungen sind dabei als Bohrungen, also mit kreisförmiger Kontur, ausgebildet, weswegen hohe Anforderung an Fertigungstoleranzen bestehen, um einen funktionierenden Zentrierbetrieb dauerhaft zu gewährleisten.

Der Erfindung liegt die Aufgabe zugrunde, einen Kontaktkopf beziehungsweise eine Prüfungseinrichtung der eingangs genannten Art zu schaffen, die ein vorteilhaftes radiales Temperaturausdehnungsspiel erlauben, jedoch kostengünstig herstellbar sind und größere Fertigungstoleranzen zulassen.

Die der Erfindung zugrundeliegende Aufgabe wird durch einen Kontaktkopf mit den Merkmalen des Anspruchs 1 beziehungsweise durch eine Prüfeinrichtung mit den Merkmalen des Anspruchs 10 gelöst. Der erfindungsgemäße Kontaktkopf hat den Vorteil, dass die Zentrierstifte in Bezug auf ihre Funktion optimiert gehalten beziehungsweise gelagert sind, sodass einerseits das radiale Temperaturausdehnungsspiel in jedem Fall gewährleistet ist, und dass andererseits der Kontaktkopf kostengünstig und mit geringerer Toleranzanforderung hergestellt werden kann. Erfindungsgemäß wird dies dadurch erreicht, dass die Zentrieröffnungen jeweils nur eine zumindest parallel zur Radialen ausgerichtete Führungsfläche aufweisen. Im Unterschied zu den aus dem Stand der Technik bereits bekannten Zentrieröffnungen, ist somit erfindungsgemäß vorgesehen, dass die Zentrieröffnungen jeweils eine, und zwar eine einzige Führungsfläche aufweisen, die zumindest parallel zu einer Radialen, die durch ein Zentrum des Kontaktkopfs führt, ausgerichtet ist. Weil somit jede der vier Zentrieröffnungen des Abstandshalters, der insbesondere ebenfalls plattenförmig ausgebildet ist, nur eine derartige zumindest parallel zur radialen ausgerichteten Führungsflächen aufweist, ist eine eindeutige Anordnung der Zentrierstifte in den Zentrieröffnungen insgesamt gewährleistet, die temperaturbedingte Größenänderungen erlaubt, ohne dadurch die Zentrierfunktion zu verlieren. Dadurch müssen bei der Herstellung der Führungsplatten insbesondere lediglich die Toleranzen der jeweils einen Führungsfläche jeder Zentrieröffnung genau eingehalten werden, während die übrige Kontur der jeweiligen Zentrieröffnung weniger genau und damit kostengünstig bearbeitet werden kann. Die fest in den Zentrieröffnungen gehaltenen Zentrierstifte gleiten dann bei einer Temperaturveränderung in dem jeweiligen Langloch zum Ausgleich der temperaturbedingten Größenänderungen.

Gemäß einer bevorzugten Weiterbildung der Erfindung ist vorgesehen, dass die Führungsflächen jeweils entlang der Radialen verlaufen. Damit sind die Führungsflächen nicht nur parallel zu der Radialen ausgerichtet, sondern verlaufen exakt entlang der Radialen. Dadurch wird erreicht, dass die Zentrierstifte nicht mit ihrem Zentrum beziehungsweise ihrer Zentralachse entlang der Radialen geführt werden, sondern mit ihrem Außenumfang. Dadurch ist eine eindeutige Führung der Zentrierstifte beziehungsweise der Führungsplatten an den Zentrierstiften sicher gewährleistet, wobei eine Überbestimmung der Führung dadurch vermieden wird, dass lediglich eine derartige Führungsfläche an der jeweiligen Zentrieröffnung ausgebildet ist.

Bevorzugt weisen die Zentrieröffnungen jeweils eine zur Führungsfläche zumindest im Wesentlichen senkrecht ausgerichtete Hilfsführungsfläche auf. Dadurch bilden die Führungsfläche und die Hilfsführungsfläche eine Art Führungsprisma oder -dreieck, durch welches der jeweilige Zentrierstift sicher geführt und ausgerichtet wird. Während die Führungsflächen vorzugsweise jeweils exakt entlang der Radialen verlaufen, ist die Anordnung der Hilfsführungsflächen weniger von Bedeutung und kann mit größeren Toleranzen behaftet sein, sodass ein sicheres Anordnen beziehungsweise Ausrichten der Führungsplatten jederzeit auch bei unterschiedlichen Temperaturen gewährleistet ist. Die Hilfsführungsflächen beschränken aufgrund ihrer senkrechten Ausrichtung die maximale Verschiebung der Führungsplatten bezüglich der Zentrierstifte, sodass beispielsweise eine Fehlmontage einfach verhindert werden kann.

Weiterhin ist bevorzugt vorgesehen, dass die Hilfsführungsflächen jeweils an einem radial innenliegenden Ende der jeweiligen Führungsfläche ausgebildet sind. Dabei liegen die Hilfsführungsflächen letztendlich zwischen den Zentrierstiften und dem Zentrum der jeweiligen Führungsplatte beziehungsweise des Kontaktkopfes. Dabei liegen Hilfsführungsflächen zweckmäßigerweise derart weit radial innen, dass ein erwartetes Temperaturspiel durch die Führungsplatten sicher kompensiert beziehungsweise ausgeglichen werden kann, ohne dass mechanische Spannungen in der Führungsplatte entstehen. Weil die Hilfsführungsflächen keine Fügungsfunktion haben, ist deren Ausführung und Toleranzgenauigkeit von untergeordneter Bedeutung.

Weiterhin ist bevorzugt vorgesehen, dass die Zentrieröffnungen quadratisch, rechteckförmig, dreiecksförmig oder bis auf die Führungsfläche und Hilfsführungsfläche kreisförmig ausgebildet sind. Dadurch ist die jeweilige Zentrieröffnung letztendlich einfach, schnell und kostengünstig herstellbar. So ist beispielsweise vorgesehen, dass die jeweilige Zentrieröffnung zunächst durch eine Bohrung begonnen und durch ein Erodieren, insbesondere Drahterodieren, der Führungsfläche und gegebenenfalls der Hilfsführungsfläche fertiggestellt wird, sodass die jeweilige Zentrieröffnung bis auf Führungsfläche und Hilfsführungsfläche kreisförmig ausgebildet ist. Dabei verbleibt ein kreisförmiger Abschnitt der Zentrieröffnung, der Führungsfläche und Hilfsführungsfläche miteinander verbindet. Auch ist es denkbar, die Zentrieröffnung bis auf Führungsfläche und gegebenenfalls Hilfsführungsfläche ovalförmig auszubilden. Alternativ wird die jeweilige Zentrieröffnung quadratisch, rechteckförmig oder dreiecksförmig ausgebildet, wobei dann durch eine der Seitenflächen die Führungsfläche und durch eine sich daran anschließende Seitenfläche die Hilfsführungsfläche gebildet wird.

Gemäß einer bevorzugten Weiterbildung der Erfindung ist vorgesehen, dass genau vier Zentrierstifte vorhanden sind. Dadurch ergibt sich eine vorteilhafte und eindeutige Führung und Lagerung der Führungsplatten beziehungsweise Zentrierstifte, die eine eindeutige Ausrichtung und Wärmeausgleichsbewegung gewährleistet.

Insbesondere ist vorgesehen, dass jeweils zwei der Zentrieröffnungen in Bezug auf das Zentrum einander diametral gegenüberliegend angeordnet sind, sodass die Führungsflächen auf einer gemeinsamen Geraden liegen, die durch das Zentrum führt. Dadurch ist eine eindeutige Anordnung und Ausrichtung der Führungsplatten sowie der in den Führungsplatten angeordneten/ausgebildeten Führungsöffnungen für die Kontaktelemente zueinander besonders sicher gewährleistet. Durch die vorteilhafte Ausrichtung und Anordnung der Führungsflächen wird außerdem eine Anforderung an Toleranz bei der Fertigung des jeweiligen Zentrierstifts reduziert oder egalisiert.

Weiterhin ist bevorzugt vorgesehen, dass die Zentrierstifte in der jeweiligen Zentrieröffnung durch eine radiale beziehungsweise seitliche Druckschraube, insbesondere durch zumindest eine Madenschraube, die radial den jeweiligen Zentrierstift mit einer Druckkraft beaufschlagt und insbesondere gegen die Führungsfläche und/oder die jeweilige Hilfsführungsfläche drückt, reibschlüssig und formschlüssig gehalten ist. Hierdurch ergibt sich eine einfache Montage und eine eindeutige Lagerung der Zentrierstifte in den Zentrieröffnungen.

Vorzugsweise sind die Zentrierstifte außerdem in Langlöchern beider Führungsplatten verschiebbar gelagert, sodass die vorteilhafte Zentrierfunktion beziehungsweise Temperaturspielfunktion beiden Führungsplatten zugutekommt.

Die Zentrierstifte können gemäß einer ersten Ausführungsform jeweils einteilig ausgebildet sein, sodass sie sich von der einen Führungsplatte, durch den gesamten Abstandshalter bis zu der anderen Führungsplatte und durch diese hindurch erstrecken. Alternativ kann vorgesehen sein, dass die Zentrierstifte zweiteilig ausgebildet sind, wobei ein erster Stiftteil in das Langloch der einen Führungsplatte und der zweite Stiftteil, der mit dem ersten Stiftteil insbesondere fluchtet, in ein Langloch der anderen Führungsplatte hineinragt, um die Zentrierung der Führungsplatten zueinander zu gewährleisten. Dabei können jeweils zwei der Stiftteile in derselben Zentrieröffnung durch jeweils eine Druckschraube gehalten sein, oder in zwei unterschiedlichen Zentrieröffnungen.

Weiterhin ist bevorzugt vorgesehen, dass die Führungsplatten aus einem Keramikwerkstoff und der Abstandshalter aus Metall gefertigt sind/ist. Hierdurch ergibt sich ein unterschiedliches Temperaturausdehnungsverhalten von Führungsplatten und Abstandshalter zueinander, was jedoch durch die vorteilhafte Zentriereinrichtung sicher kompensiert beziehungsweise derart beeinflusst wird, dass die Anordnung der Kontaktelemente, die insbesondere als Kontaktstifte oder Kontaktnadeln ausgebildet sind, wie zuvor beschrieben gewährleistet ist.

Die elektrische Prüfeinrichtung mit den Merkmalen des Anspruchs 10 zeichnet sich durch den erfindungsgemäßen Kontaktkopf aus. Es ergeben sich hierdurch die bereits genannten Vorteile.

Weitere Vorteile und bevorzugte Merkmale und Merkmalskombination ergeben sich insbesondere aus dem zuvor beschriebenen sowie aus den Ansprüchen. Im Folgenden soll die Erfindung anhand der Zeichnungen näher erläutert werden.
- Figur 1: eine elektrische Prüfeinrichtung in einer vereinfachten Darstellung,
- Figur 2: Führungsplatten eines Kontaktkopfes der Prüfeinrichtung,
- Figur 3: den Kontaktkopf gemäß eines bekannten Ausführungsbeispiels,
- Figur 4: ein vorteilhaftes Ausführungsbeispiel des Kontaktkopfs in einer schematisierten Darstellung und
- Figur 5: eine Detailansicht des vorteilhaften Ausführungsbeispiels.

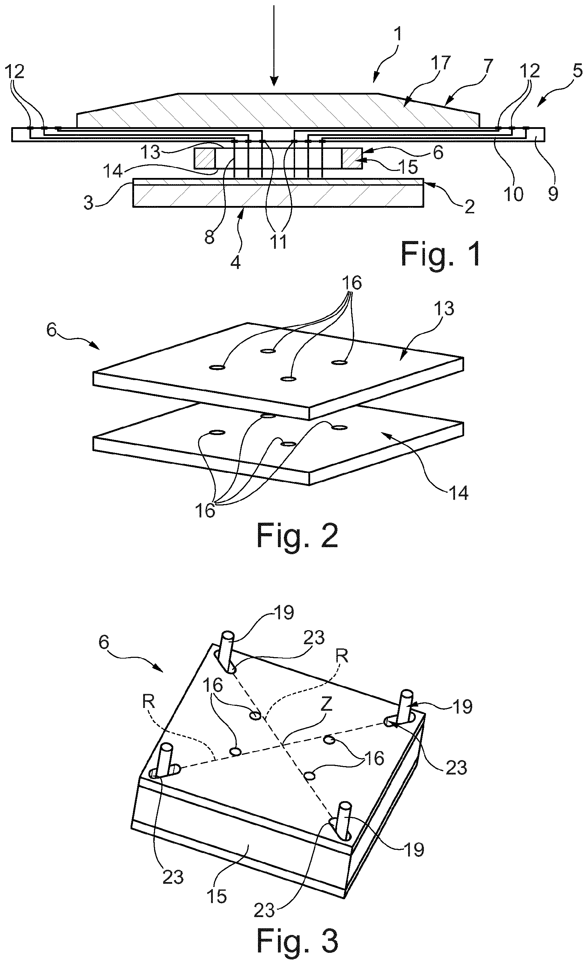

Figur 1 zeigt in einer schematischen Darstellung den Querschnitt einer elektrischen Prüfeinrichtung 1, die dazu ausgebildet ist, ein Substrat 2, das eine Vielzahl elektrischer Kontaktstellen aufweist, elektrisch zu kontaktieren. Das Substrat 2 ist beispielsweise als Wafer 3, Leiterplatte oder Solarzelle ausgebildet und auf einem Träger 4, insbesondere der Prüfeinrichtung 1, ablegbar. Der Träger 4, auch Chuck bezeichnet, ist derart ausgebildet, dass er gekühlt oder geheizt werden kann, wobei hierfür bevorzugt eine Kühleinrichtung und/oder eine Heizeinrichtung in den Träger 4 integriert beziehungsweise an diesem angeordnet sind. Hierdurch ist es möglich, das Substrat 2 während der Durchführung einer Prüfung unterschiedlichen Temperaturen auszusetzen, um die Funktionsfähigkeit des Substrats 2 auch bei unterschiedlichen Temperaturen feststellen zu können. Zur Kontaktierung des Substrats 2 weist die Prüfeinrichtung 1 eine sogenannte Prüfkarte 5 auf, die zur Durchführung der Prüfung einen Kontaktkopf 6 sowie eine Anschlussvorrichtung 7 aufweist. Der Kontaktkopf 6 trägt eine Vielzahl von längsverschieblich gelagerten, stiftförmigen Kontaktelementen 8, die parallel zueinander ausgerichtet sind. Die Kontaktelemente 8 sind jeweils mit einem ersten Ende dem Träger 4 beziehungsweise dem Substrat 2 zugewandt. Das andere Ende der Kontaktelemente 8 ist jeweils der Anschlussvorrichtung 7 zugeordnet.

Die Anschlussvorrichtung 7 ist vorliegend als mehrlagige Leiterplatte 9 ausgebildet, die eine Vielzahl von elektrisch leitfähigen Leiterbahnen aufweist. Die Leiterbahnen weisen an ihrem dem Kontaktkopf 6 jeweils zugeordneten Ende Kontaktflächen 11 auf, die durch die Kontaktelemente 8 berührungskontaktiert werden können. An ihrem von dem Kontaktkopf 6 wegweisenden und radial ausliegenden Enden weisen die Leiterbahnen 10 jeweils eine Anschlussfläche 12 auf, die über nicht dargestellte Kabelverbindungen mit einem hier nicht dargestellten Prüfsystem verbindbar sind.

Die Anschlussvorrichtung 7 bildet insofern eine Umsetzvorrichtung, die einen sehr engen Abstand der sehr kleinen Kontaktflächen 11 über die Leiterbahnen 10 in größere Abstände der Anschlussflächen 13 zueinander umsetzt, sodass die Kontaktflächen 11 einfacher elektrisch kontaktiert werden können, und wobei die Anordnung der Kontaktflächen 11 der Anordnung der stiftförmigen Kontaktelemente 8 auf engem Raster entspricht. Die Größe der Kontaktflächen 11 ist dabei entsprechend derart gewählt, dass eine sichere Berührungskontaktierung durch die Kontaktelemente 8 stattfinden kann, während die Größe der Anschlussflächen 12 derart gewählt ist, dass eine einfache elektrische Kontaktierung 11, beispielsweise durch Verbindungskabel und Lötstellen, gewährleistet ist.

Bei der Prüfung des Substrats 2 bewegt sich die Anschlussvorrichtung 7 in Richtung des Trägers 4 und/oder der Träger 4 in Richtung der Anschlussvorrichtung 7 in axialer Richtung der Kontaktelemente 8, sodass die Enden beziehungsweise Stirnenden der Kontaktelemente 8 einerseits auf den Kontaktflächen des Substrats 2 und andererseits auf die Kontaktflächen 11 auftreffen, sodass eine elektrische Verbindung von dem Substrat 2 zu der Anschlussvorrichtung 7 hergestellt wird. Sind die Kontaktelemente 8 bevorzugt als Knickdrähte ausgebildet, können diese seitlich ausfedern und dadurch eine einwandfreie Kontaktierung aller Kontaktstellen sicher gewährleisten. Damit eine ausreichende Kraft auf die Kontaktelemente ausgeübt werden kann, ohne dass die Leiterplatte 9 durch die Belastung sich verformt, ist dieser eine Stützplatte 17 zugeordnet, wie durch ein Pfeil in Figur 1 gezeigt.

Zur Führung und Halterung der Kontaktelemente 8 weist der Kontaktkopf 6 zwei beabstandet zueinander und parallel zueinander angeordnete Führungsplatten 13, 14 auf. Die Führungsplatten 13, 14 sind durch einen Abstandhalter 15 zueinander ausgerichtet.

Figur 2 zeigt hierzu in einer vereinfachten perspektivischen Darstellung die zwei Führungsplatten 13, 14, die parallel zueinander angeordnet sind. Beide Führungsplatten 13, 14 weisen jeweils eine Vielzahl von Führungsöffnungen 16 auf, die derart ausgebildet und an den Führungsplatten 13, 14 angeordnet sind, dass jeweils ein Kontaktelement 8 durch zwei miteinander fluchtende oder versetzte Führungsöffnungen 16 der beiden Führungsplatten 13, 14 hindurchführbar ist und dadurch von den Führungsplatten geführt und bevorzugt reibschlüssig gehalten ist. Gemäß dem in Figur 2 gezeigten Ausführungsbeispiel sind lediglich vier Führungsöffnungen 16 in jeder der Führungsplatten 13, 14 gezeigt, tatsächlich weisen die Führungsplatten 13, 14 eine hohe Anzahl der Führungsöffnungen 16 auf. Dabei ist zu erkennen, dass jeder Führungsöffnung 16 der Führungsplatte 13 eine damit fluchtende beziehungsweise korrespondieren Führungsöffnung 16 in der Führungsplatte 14 ausgebildet ist. Der Abstand zwischen den Führungsplatten 13, 14 ist vorteilhaft für das seitliche Ausknicken beziehungsweise Ausfedern der Kontaktelemente 8 bei der Durchführung der Prüfung, wie zuvor beschrieben, ausgebildet.

Während die Führungsplatten 13, 14 aus Keramik gefertigt sind, ist der Abstandshalter 15 aus Stahl gefertigt. Dies führt dazu, dass sich bei einer Temperaturänderung die Führungsplatten 13, 14 und der Abstandshalter 15 auch aufgrund ihrer unterschiedlichen Temperaturausdehnungskoeffizienten unterschiedlich verhalten können. Insbesondere können sich die Führungsplatten 13, 14 in ihrer jeweiligen Ebene temperaturbedingt ausdehnen, was dazu führt, dass die Kontaktelemente 8, die in den Führungsöffnungen 16 gehalten sind, mit den Führungsplatten 13, 14 mitbewegt werden. Dies wiederum kann dazu führen, dass die Kontaktelemente 8 nicht mehr auf die Kontaktflächen 11 oder die Kontaktstellen des Substrats 2 treffen und dadurch eine Durchführung der Prüfung nicht mehr sicher gewährleistet ist. Es ist daher bereits bekannt, eine Zentriereinrichtung 20 vorzusehen, welche eine Mittenzentrierung für die Führungsplatten 13, 14 bildet.

Figur 3 zeigt eine derartige Zentriervorrichtung 20 anhand eines perspektivisch dargestellten Ausführungsbeispiels. Dabei sind in den Führungsplatten Langlöcher 23 ausgebildet, die sich in ihrer Längserstreckung radial zum Zentrum Z der jeweiligen Führungsplatte 13, 14 hin erstrecken. In dem Abstandshalter 15 befestigte Zentrierstifte 19 ragen jeweils in eines der Langlöcher 23 hinein und sind derart ausgebildet, dass sie längsverschieblich in den Langlöchern 23, also auf einer gedachten Radialen R zum Zentrum Z in dem jeweiligen Langloch 23 verschiebbar sind. Treten nun temperaturbedingte Größenänderungen ein, so können sich die Führungsplatten 13, 14 nur radial in der Ebene vergrößern oder verkleinern, und zwar ausgehend vom Zentrum Z, sodass gewährleistet ist, dass die Führungsöffnungen 16 nur minimal in ihrer Position durch eine Temperaturausdehnung beeinflusst werden. Weil dies ausgehend vom Zentrum Z erfolgt, ist sichergestellt, dass sich die Längenausdehnungen nicht über die gesamte Breite oder Länge der jeweiligen Führungsplatte 13, 14 addieren.

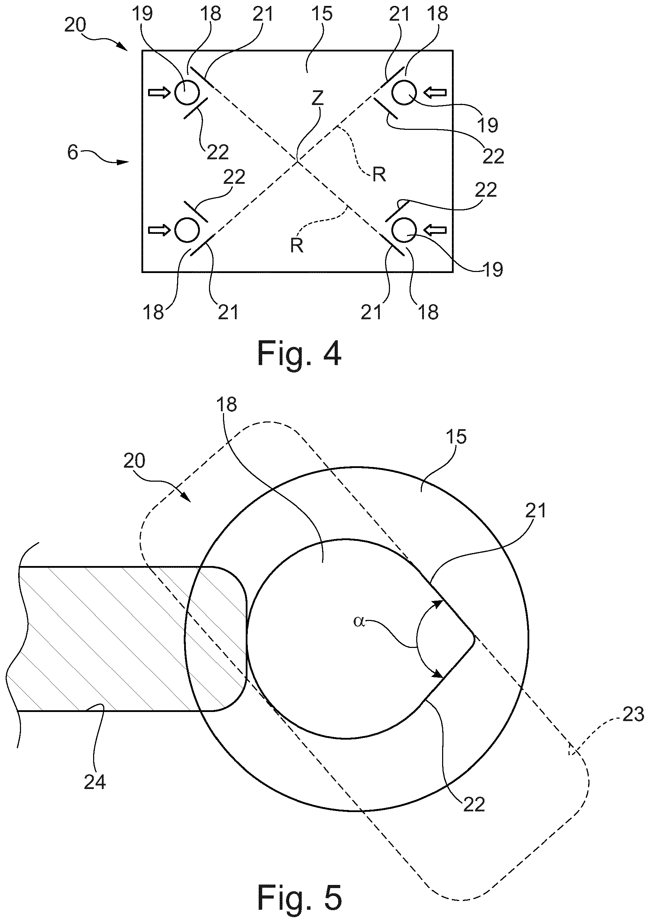

Figur 4 zeigt den Kontaktkopf 6 mit einer der vorteilhaften Zentriereinrichtung 20. Figur 4 zeigt dazu die Zentriereinrichtung 20 in einer schematisierten Draufsicht auf den Abstandshalter 15. In dem Abstandshalter sind mehrere Zentrieröffnungen 18 ausgebildet Gemäß dem vorteilhaften Ausführungsbeispiel ist vorgesehen, dass die Zentrieröffnungen 18 jeweils eine Führungsfläche 21 aufweisen, die nicht nur parallel, sondern genau entlang der jeweiligen Radialen R verläuft. Senkrecht oder alternativ in einem spitzen Winkel zu der Führungsfläche 21 ist jeweils eine Hilfsführungsfläche 22 ausgebildet, sodass die Führungsfläche 21 und die Hilfsführungsfläche 22 zusammen eine dreieckförmige oder prismenförmige Zentrierkontur bilden.

Figur 5 zeigt dazu in einer vergrößerten Darstellung eine der Zentrieröffnungen 18, die in Figur 4 oben links in dem Abstandshalter 15 ausgebildet ist, der Zentriereinrichtung 20 in einer vergrößerten Detailansicht. Zu erkennen sind dabei die Führungsfläche 21 sowie Hilfsführungsfläche 22, die gemäß dem vorliegenden Ausführungsbeispiel einen Winkel α = 90° zwischen sich einschließen, wobei die Führungsfläche 21 auf der Radialen R zum Zentrum Z liegen. Die Führungsfläche 21 und Hilfsführungsfläche 22 sind gemäß dem vorliegenden Ausführungsbeispiel gleich lang ausgebildet und gehen in eine Kreisbogenkontur der Zentrieröffnung 18 über, welche die Kontur der Zentrieröffnung 18 aufweist.

Zur Herstellung der Zentrieröffnungen 18 ist insbesondere vorgesehen, dass die Zentrieröffnungen 18 durch Erodieren, insbesondere Drahterodieren der Führungsfläche 21 und der Hilfsfläche 22 in dem Abstandshalter 15 hergestellt wird. Weil nur die Führungsfläche 21 eine für die Zentrierung und den Toleranzausgleich wichtige Funktion zu erfüllen hat, muss nur bei dieser auf das Einhalten enger Toleranzen geachtet werden. Die übrige Kontur der Zentrieröffnung 18 ist weniger relevant, weil im Normalfall keiner der Zentrierstifte 19 an der übrigen Kontur der jeweiligen Zentrieröffnungen 18 anliegt. Weil die Zentrieröffnung 18 keine parallelen Führungsflächen aufweisen und somit immer einen Abstand und eine Dimension der Ausdehnung haben, ist die gegenüberliegende Seite der jeweiligen Führungsfläche 21 für die Führung des Zentrierstifts 19 unbedeutend, sodass dort entsprechend große Toleranzen bei der Fertigung berücksichtigt werden können. Figur 5 zeigt außerdem mit gestrichelten Linien die Ausrichtung des der Zentrieröffnung 18 zugeordneten Langlochs 23.

Gemäß dem vorherigen Ausführungsbeispiel sind genau vier derartige Zentrieröffnungen 18 vorgesehen, wobei jeweils zwei der Zentrieröffnungen 18 einander diametral gegenüberliegen zu dem Zentrum Z in des Abstandshalters 15 beziehungsweise des Kontaktkopfs 6 ausgebildet sind. Weil die Führungsflächen 21 entlang der Radialen R verlaufen, erfolgt keine Addition der Toleranzen mit der Folge, dass auch die Herstellungstoleranzen der Zentrierstifte 19 größer ausfallen können als bisher. Die Anordnung und Ausbildung der Hilfsführungsflächen 22 muss weniger genau sein als bisher, auch muss nicht ein genauer rechter Winkel zwischen den Hilfsführungsflächen 22 und der jeweils zugeordneten Führungsflächen 21 vorhanden sein. Vielmehr können auch von dem rechten Winkel abweichenden Winkel α vorhanden sein. Die Größe der jeweiligen Zentrieröffnung 18 muss lediglich insgesamt größer sein als der Durchmesser des jeweiligen Zentrierstifts 19, um die Montage des jeweiligen Zentrierstifts 19 zu ermöglichen.

Bei der Montage werden die Zentrierstifte 19, insbesondere durch seitliche Druckschrauben 24, insbesondere mittels Madenschrauben, an dem Abstandshalter 15 derart befestigt, dass sie aufeinander zu in Richtung des Zentrums mit einer Befestigungskraft beaufschlagt werden, wie in Figur 4 durch Pfeile und in Figur 5 durch gestrichelte Linien gezeigt. Dadurch werden die Zentrierstifte 19 jeweils gegen die jeweilige Führungsfläche 21 gedrängt, sodass eine Ausrichtung bei der Montage auf einfache Art und Weise gewährleistet wird.

Kommt es nun zu Temperaturspannungen oder temperaturbedingten Längenänderungen in einer der Führungsplatten 13, 14, so können sich die Führungsplatten 13, 14 auch wie zuvor bereits radial ausdehnen, ohne dass die Führungsöffnungen 16 und damit die Kontaktelemente 8 zu weit von einer vorgegebenen Position abweichen. Auch die Ausrichtung der Führungsöffnung 16 zueinander wird dabei derart aufrechterhalten, sodass eine ausreichende Haltekraft zum insbesondere reibschlüssigen Halten der Kontaktelemente 8 gewährleistet wird.

## Patentansprüche

1. Kontaktkopf (6) für eine elektrische Prüfeinrichtung (1) zur elektrischen Prüfung von Substraten, die elektrische Kontaktstellen aufweisen, mit zumindest zwei Führungsplatten (13,14) die durch einen Abstandshalter (15) zueinander angeordnet sind und jeweils mehrere miteinander fluchtende oder versetzte Führungsöffnungen (16) zur Aufnahme stiftförmiger Kontaktelemente (8) aufweisen und durch eine Zentriereinrichtung (20) zueinander ausgerichtet sind, wobei die Zentriereinrichtung (20) vier Zentrierstifte (19) aufweist, die in jeweils einem sich auf das Zentrum (Z) des Kontaktkopfs (6) zu erstreckenden Langloch (23) in zumindest einer der Führungsplatten (13,14) verschiebbar gelagert sind, und wobei die Zentrierstifte (19) jeweils in einer Zentrieröffnung (18) des Abstandshalters (15) gehalten sind, **dadurch gekennzeichnet, dass** die Zentrieröffnungen (18) jeweils nur eine parallel zu einer Radialen (R) - in Bezug auf das Zentrum (Z) - ausgerichtete Führungsfläche (21) aufweisen.

2. Kontaktkopf nach Anspruch 1, **dadurch gekennzeichnet, dass** die Führungsflächen (21) jeweils entlang der Radialen (R) verlaufen.

3. Kontaktkopf nach einem der vorhergehenden Ansprüche, **dadurch gekennzeichnet, dass** die Zentrieröffnungen (18) jeweils eine zur Führungsfläche (21) senkrecht ausgerichtete Hilfsführungsfläche (22) aufweisen.

4. Kontaktkopf nach einem der vorhergehenden Ansprüche, **dadurch gekennzeichnet, dass** die jeweilige Hilfsführungsfläche (22) jeweils an einem radial innenliegenden Ende der jeweiligen Führungsfläche (21) ausgebildet/angeordnet ist.

5. Kontaktkopf nach einem der vorhergehenden Ansprüche, **dadurch gekennzeichnet, dass** die Zentrieröffnungen (18) quadratisch, rechteckförmig, dreiecksförmig oder bis auf die Führungsfläche (21) und die Hilfsführungsfläche (22) kreisförmig ausgebildet sind.

6. Kontaktkopf nach einem der vorhergehenden Ansprüche, **dadurch gekennzeichnet, dass** jeweils zwei der Zentrieröffnungen (18) in Bezug auf das Zentrum (Z) einander diametral gegenüberliegend angeordnet sind.

7. Kontaktkopf nach einem der vorhergehenden Ansprüche, **dadurch gekennzeichnet, dass** die Zentrierstifte (19) in Langlöchern (23) beider Führungsplatten (13,14) verschiebbar gelagert sind.

8. Kontaktkopf nach einem der vorhergehenden Ansprüche, **dadurch gekennzeichnet, dass** die Zentrierstifte (19) durch radiale Druckschrauben (24), insbesondere Madenschrauben, in den Zentrieröffnungen (18) befestigt sind.

9. Kontaktkopf nach einem der vorhergehenden Ansprüche, **dadurch gekennzeichnet, dass** die Führungsplatten (13,14) aus einem Keramikwerkstoff und der Abstandshalter (15) aus Metall gefertigt sind/ist.

10. Elektrische Prüfeinrichtung (1) zur elektrischen Prüfung von Substraten (2), die elektrische Leiter und/oder elektrische/elektronische Komponenten aufweisen, mit einer Anschlussvorrichtung (7) und einem Kontaktkopf (6), **gekennzeichnet durch** die Ausbildung des Kontaktkopfs (6) nach einem oder mehreren der Ansprüche 1 bis 9.

## Claims

1. Contact head (6) for an electrical test device (1) for electrically testing substrates, which have electrical contact points, with at least two guide plates (13, 14) that are arranged to each other by a spacer (15) and each have guide openings (16) aligned or offset with each other for receiving pin-shaped contact elements (8) and are oriented to each other by a centering device (20), wherein the centering device (20) has four centering pins (19), which are displaceably mounted in a slot (23), extending toward the center (Z) of the contact head (6), in at least of one of the guide plates (13, 14), and wherein the centering pins (19) are each held in a centering opening (18) of the spacer (15), **characterized in that** the centering openings (18) each have only one guide surface (21) oriented parallel to a radial axis (R) - in relation to the center (Z).

2. Contact head according to claim 1, **characterized in that** the guide surfaces (21) each run along the radial axis (R).

3. Contact head according to one of the preceding claims, **characterized in that** the centering openings (18) each have one supplementary guide surface (22) oriented perpendicular to the guide surface (21).

4. Contact head according to one of the preceding claims, **characterized in that** the respective supplementary guide surface (22) is constructed/arranged in each case on a radially inward end of the respective guide surface (21).

5. Contact head according to one of the preceding claims, **characterized in that** the centering openings (18) are constructed in a square, rectangular, triangular, or, except for the guide surface (21) and supplementary guide surface (22), circular manner.

6. Contact head according to one of the preceding claims, **characterized in that** in each case two of the centering openings (18) are arranged diametrically opposite each other in relation to the center (Z).

7. Contact head according to one of the preceding claims, **characterized in that** the centering pins (19) are displaceably positioned in slots (23) of both guide plates (13, 14).

8. Contact head according to one of the preceding claims, **characterized in that** the centering pins (19) are attached by radial setscrews (24), particularly grub screws, in the centering openings (18).

9. Contact head according to one of the preceding claims, **characterized in that** the guide plates (13, 14) are produced of a ceramic material and the spacer (15) is produced of a metal.

10. Electrical test device (1) for electrically testing substrates (2), which have electrical conductors and/or electric/electronic components, having a connection device (7) and a contact head (6), **characterized by** the construction of the contact head (6) according to one or more of the claims 1 to 9.

## Revendications

1. Tête de contact (6) pour un dispositif de contrôle électrique (1) pour le contrôle électrique de substrats qui présentent des points de contact électriques, avec au moins deux plaques de guidage (13, 14) qui sont séparées par un espaceur (15), présentent respectivement plusieurs ouvertures de guidage (16) alignées ou décalées pour la réception d'éléments de contact en forme de tige (8) et sont orientées les unes par rapport aux autres au moyen d'un dispositif de centrage (20), le dispositif de centrage (20) présentant quatre goupilles de centrage (19) qui, respectivement dans un trou oblong (23) s'étendant vers le centre (Z) de la tête de contact (6), sont disposées de manière déplaçable dans au moins l'une des plaques de guidage (13, 14) et les goupilles de centrage (19) étant respectivement maintenues dans une ouverture de centrage (18) de l'espaceur (15), **caractérisée en ce que** les ouvertures de centrage (18) présentent respectivement seulement une surface de guidage (21) orientée parallèlement à une ligne radiale (R) par rapport au centre (Z).

2. Tête de contact selon la revendication 1, **caractérisée en ce que** les surfaces de guidage (21) passent respectivement le long de la ligne radiale (R).

3. Tête de contact selon l'une des revendications précédentes, **caractérisée en ce que** les ouvertures de centrage (18) présentent respectivement une surface de guidage auxiliaire (22) orientée perpendiculairement par rapport à la surface de guidage (21).

4. Tête de contact selon l'une des revendications précédentes, **caractérisée en ce que** la surface de guidage auxiliaire (22) respective est respectivement formée/disposée à une extrémité radialement intérieure de la surface de guidage (21) respective.

5. Tête de contact selon l'une des revendications précédentes, **caractérisée en ce que** les ouvertures de centrage (18) sont de forme carrée, rectangulaire, triangulaire ou, jusqu'à la surface de guidage (21) et la surface de guidage auxiliaire (22), de forme circulaire.

6. Tête de contact selon l'une des revendications précédentes, **caractérisée en ce que** respectivement deux des ouvertures de centrage (18) sont diamétralement opposées par rapport au centre (Z).

7. Tête de contact selon l'une des revendications précédentes, **caractérisée en ce que** les goupilles de centrage (19) sont disposées de manière déplaçable dans des trous oblongs (23) des deux plaques de guidage (13, 14).

8. Tête de contact selon l'une des revendications précédentes, **caractérisée en ce que** les goupilles de centrage (19) sont fixées dans les ouvertures de centrage (18) au moyen de vis de pression radiales (24), en particulier de vis sans tête.

9. Tête de contact selon l'une des revendications précédentes, **caractérisée en ce que** les plaques de guidage (13, 14) sont fabriquées dans un matériau céramique et l'espaceur (15) en métal.

10. Dispositif de contrôle électrique (1) pour le contrôle électrique de substrats (2) qui présentent des conducteurs électriques et/ou des composants électriques/électroniques, avec un dispositif de connexion (7) et une tête de contact (6), **caractérisé en ce que** la tête de contact (6) est formée selon une ou plusieurs des revendications 1 à 9.
